# EUROPÄISCHE PATENTSCHRIFT

(11) **EP 1 112 618 B1**
(45) Veröffentlichungstag und Bekanntmachung des Hinweises auf die Patenterteilung: **12.04.2006**
(21) Anmeldenummer: 99953653.5
(22) Anmeldetag: 01.09.1999
(51) Int. Cl.: H03K 3/037

(54) **DIGITALE SCHALTUNG**
DIGITAL CIRCUIT
CIRCUIT NUMERIQUE

(30) Priorität: 09.09.1998 DE 19841203
(43) Veröffentlichungstag der Anmeldung: 04.07.2001
(73) Patentinhaber: Infineon Technologies AG, 81669 München (DE)
(72) Erfinder: LE, Thoai-Thai, D-81737 München (DE)
(74) Vertreter: Müller - Hoffmann & Partner
(86) Internationale Anmeldenummer: PCT/DE1999/002739
(87) Internationale Veröffentlichungsnummer: WO 2000/014874

(56) Entgegenhaltungen:
- US-A- 5 144 168
- US-A- 5 306 970

## Beschreibung

Die Erfindung betrifft eine digitale Schaltung nach dem Oberbegriff des Patentanspruches 1. Eine derartige Schaltung ist beispielsweise aus der US-A-5 144 168 bekannt. Weiterhin ist in der US-A-5 306 970 eine Schaltung beschrieben, bei der ein Schaltelement, das unter bestimmten Umständen gesperrt ist, in einem Rückkopplungszweig zwischen Ausgang und Eingang liegt.

Der Erfindung liegt die Aufgabe zugrunde, eine digitale Schaltung mit reduzierter Leistungsaufnahme anzugeben, die nach einem Versetzen in einen aktivierten Zustand ein Eingangssignal in nicht invertiertem und in invertiertem Zustand an entsprechenden Ausgängen ausgibt und die nach ihrer Aktivierung eine zeitgünstige Abkopplung vom Eingangssignal ermöglicht, sobald dessen Pegel von ihm erfaßt worden ist.

Diese Aufgabe wird mit einer digitalen Schaltung gemäß Patentanspruch 1 gelöst. Vorteilhafte Aus- und Weiterbildungen, der Erfindung sind Gegenstand abhängiger Ansprüche.

Die digitale Schaltung weist einen Eingang zur Zuführung eines Eingangssignals über ein erstes Schaltelement auf sowie einen Aktivierungseingang, über den sie in einen aktivierten und einen deaktivierten Zustand versetzbar ist. Ferner hat sie einen ersten Ausgang, an dem sie im aktivierten Zustand denjenigen Pegel des Eingangssignals nicht invertiert ausgibt, den dieses direkt vor einem Sperren des ersten Schaltelementes aufweist, und einen zweiten Ausgang, an dem sie im aktivierten Zustand denjenigen Pegel des Eingangssignals invertiert ausgibt, den dieses direkt vor dem Sperren des ersten Schaltelementes aufweist. Sie gibt im deaktivierten Zustand an beiden Ausgängen einen ersten logischen Pegel aus. Außerdem hat die digitale Schaltung eine Logikeinheit, die eingangsseitig mit den beiden Ausgängen der Schaltung verbunden ist und die ausgangsseitig mit einem Steueranschluß des ersten Schaltelementes verbunden ist. Die Logikeinheit schaltet das erste Schaltelement leitend, wenn an beiden Ausgängen der Schaltung der erste logische Pegel anliegt. Die Logikeinheit sperrt das erste Schaltelement, wenn an einem der beiden Ausgänge ein zweiter logischer Pegel anliegt.

Solange also die digitale Schaltung deaktiviert ist, gibt die Schaltung an ihren beiden Ausgängen den gleichen logischen Pegel aus, wodurch das erste Schaltelement über die Logikeinheit leitend geschaltet wird. Das bedeutet, daß das Eingangssignal am Eingang der digitalen Schaltung während dieses Zeitraums über das erste Schaltelement mit weiteren Komponenten der digitalen Schaltung verbunden ist. Der Pegel des Eingangssignals wirkt sich dabei nicht auf die Ausgangssignale der digitalen Schaltung aus. Sobald die digitale Schaltung über ihren Aktivierungseingang in den aktiven Zustand versetzt wird, sind die Signale an den beiden Ausgängen der digitalen Schaltung komplementär zueinander. Welchen Pegel die beiden Ausgangssignale aufweisen, ist abhängig vom Pegel des Eingangssignals beim Wechsel in den aktivierten Zustand. Die Logikeinheit erkennt durch die Überwachung der Ausgangssignale aufgrund ihrer unterschiedlichen Pegel, daß sich die digitale Schaltung im aktivierten Zustand befindet und daß der aktuelle geltende Pegel des Eingangssignals an den ersten Ausgang in nicht invertierter Form und an den zweiten Ausgang in invertierter Form ausgegeben wurde. Zu diesem Zeitpunkt sperrt die Logikeinheit das erste Schaltelement, so daß sich anschließend weitere Pegeländerungen des Eingangssignals nicht auf die Ausgangssignale auswirken. Letztere behalten solange ihren Pegel bei, bis die digitale Schaltung wieder in den deaktivierten Zustand versetzt wird, wodurch ein Rücksetzen der Ausgangssignale auf den ersten logischen Pegel erfolgt.

Die Schaltung hat den Vorteil, daß das Sperren des ersten Schaltelementes zeitoptimal erfolgt, da es abhängig vom Pegelwechsel der Ausgangssignale durchgeführt wird. Somit ist es unerheblich, wie viel Zeit zwischen der Aktivierung der digitalen Schaltung und der Ausgabe des Pegels des Eingangssignals in nicht invertierter beziehungsweise in invertierter Form vergeht. Es entfällt somit die Notwendigkeit, diese Zeitspanne zu messen und durch ein Laufzeitglied nachzubilden, das alternativ zum Sperren des ersten Schaltelementes verwendet werden könnte. Da die digitale Schaltung das Sperren ihres erstes Schaltelementes automatisch und zeitoptimiert durchführt, entfällt die Notwendigkeit eines solchen Laufzeitgliedes und der damit verbundene Entwicklungsaufwand bezüglich seiner Dimensionierung.

Weiterhin weist die digitale Schaltung eine Haltereinheit mit einem Rückkopplungszweig auf, die nach dem Sperren des ersten Schaltelementes eine Änderung der Pegel an den Ausgängen der Schaltung verhindert, solange die Schaltung aktiviert ist. Außerdem hat sie ein zweites Schaltelement, daß im Rückkopplungszweig angeordnet ist und das einen Steuereingang aufweist, der mit dem Ausgang der Logikeinheit verbunden ist. Die Logikeinheit sperrt das zweite Schaltelement, wenn an beiden Ausgängen der Schaltung der erste logische Pegel anliegt, während sie das zweite Schaltelement leitend schaltet, wenn an einem der beiden Ausgänge der zweite logische Pegel anliegt.

Das erste und das zweite Schaltelement werden also jeweils in entgegengesetzte Schaltzustände versetzt. Durch das zweite Schaltelement ist gewährleistet, daß der Rückkopplungszweiq und damit die Halteeinheit nur aktiv ist, wenn die beiden .. Ausgänge der digitalen Schaltung bereits unterschiedliche Pegel aufweisen. Erst dann wird das erste Schaltelement gesperrt, so daß das Eingangssignal keinen Einfluß mehr auf die Pegel der Ausgangssignale hat. Durch Schließen des zweiten Schaltelementes wird der Zustand der Ausgangssignale gehalten. Solange jedoch das erste Schaltelement leitend geschaltet ist, ist das zweite Schaltelement gesperrt, so daß über den dann unterbrochenen Rückkopplungszweig keine Verlustströme fließen. Somit wird die Leistungsaufnahme der digitalen Schaltung reduziert.

Die Erfindung wird im folgenden anhand der Figuren näher erläutert, die Ausführungsbeispiele der Erfindung zeigen. Es zeigen:
- Figur 1: ein Blockschaltbild der digitalen Schaltung,
- Figur 2: eine erste nicht zur Erfindung gehörende ausfürhrungsform der digitalen Schaltung aus Figur 1,
- Figur 3: eine zweite Ausführungsform der Schaltung aus Figur 1 und
- Figur 4: eine dritte Ausführungsform der Schaltung aus Figur 1.

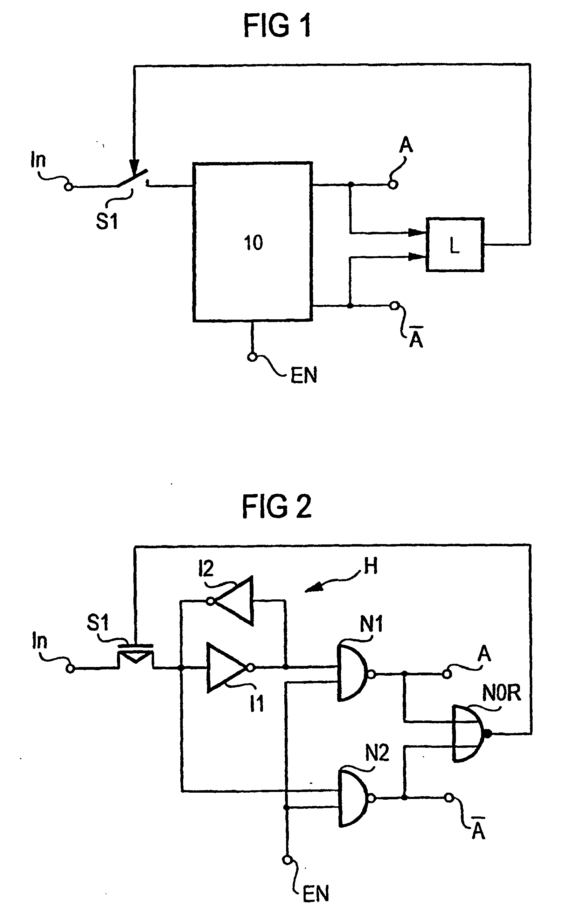

Figur 1 zeigt eine digitale Schaltung mit einem Eingang In und zwei Ausgängen A, /A. Die Schaltung weist Schaltungseinheiten 10 auf, denen ein Eingangssignal über den Eingang In und ein diesem nachgeschaltetes erstes Schaltelement S1 zugeführt wird. Die Schaltungseinheiten 10 sind mit einem Aktivierungseingang EN verbunden, über den die Schaltung in einem aktivierten und in einen deaktivierten Zustand versetzbar ist. Während die Schaltungseinheiten 10 an den beiden Ausgängen A, /A im deaktivierten Zustand der digitalen Schaltung einen ersten logischen Pegel ausgeben, sorgt eine Logikeinheit L, die mit beiden Ausgängen verbunden ist, dafür, daß das erste Schaltelement S1 leitend geschaltet ist. Ist die digitale Schaltung aktiviert, liegt der Pegel des Eingangssignals nicht invertiert am ersten Ausgang A und invertiert am zweiten Ausgang /A an. Die Logikeinheit L erkennt diesen Zustand der Ausgangssignale und sperrt daraufhin das erste Schaltelement S1, so daß sich anschließende Pegeländerungen des Eingangssignals am Eingang In nicht mehr auf die Schaltungseinheiten 10 und damit auf den Pegel der Ausgangssignale an den Ausgängen A, /A auswirken.

Figur 2 zeigt ein konkretes, Ausführungsbeispiel der digitalen Schaltung aus Figur 1. Dieses Ausführungsbeispiel gehört nicht zur Erfindung und fällt nicht unter die Patentansprüche. Das erste Schaltelement S1 ist durch einen p-Kanal-Transistor realisiert. Die Logikeinheit L ist durch ein NOR-Gatter realisiert. Der Eingang In ist über das erste Schaltelement S1 und einen ersten Inverter I1 mit einem ersten Eingang eines ersten NAND-Gatters N1 verbunden. Weiterhin ist der Eingang In über das erste Schaltelement S1 mit einem ersten Eingang eines zweiten NAND-Gatters N2 verbunden. Zweite Eingänge der beiden NAND-Gatter N1, N2 sind mit dem Aktivierungseingang EN verbunden. Die Ausgänge der beiden NAND-Gatter N1, N2 sind die Ausgängen A, /A Schaltung. Der Ausgang des ersten Inverter I1 ist über einen Rückkopplungszweig, der einen zweiten Inverter I2 aufweist, mit seinem Eingang verbunden. Die beiden Inverter I1, I2 bilden eine Halteschaltung H.

Die Funktionsweise der in Figur 2 gezeigten Schaltung ist folgende:

Solange ein Aktivierungssignal am Aktivierungseingang EN einen niedrigen logischen Pegel aufweist, stellt sich an den Ausgängen A, /A, unabhängig vom Pegel des Eingangssignals am Eingang In, ein hoher logischer Pegel (logisch Eins) ein. Am Ausgang des NOR-Gatters ergibt sich ein niedriger logischer Pegel (logisch Null), so daß das erste Schaltelement S1 leitend geschaltet ist. Das Eingangssignal am Eingang In wird somit dem Eingang des ersten Inverter I1 und dem ersten Eingang des zweiten NAND-Gatters N2 zugeführt. In diesem deaktivierten Zustand der digitalen Schaltung wird das Potential am Eingang des ersten Inverters I1 hauptsächlich durch das Eingangssignal bestimmt, da (nicht dargestellte) Treiber des Eingangssignals stärker als der zweite Inverter I2 dimensioniert sind. Sobald das Aktivierungssignal am Aktivierungseingang EN auf den hohen logischen Pegel wechselt, wird die digitale Schaltung in ihren aktiven Zustand versetzt. Die zu diesem Zeitpunkt am Eingang beziehungsweise am Ausgang des ersten Inverters I1 vorhandenen Pegel bewirken, daß entweder der Pegel am ersten Ausgang A oder am zweiten Ausgang /A von 1 auf 0 wechselt. Sobald das NOR-Gatter diesen Pegelwechsel detektiert, wechselt dessen Ausgangssignal von 0 auf 1, so daß das erste Schaltelement S1 gesperrt wird. Die digitale Schaltung ist somit von ihrem Eingang In abgekoppelt, so daß sich anschließende Pegelwechsel des Eingangssignals nicht mehr auf den Pegel der Ausgangssignale auswirken. Die Halteeinheit H sorgt dafür, daß der direkt vor dem Sperren des ersten Schaltelementes S1 anliegende Pegel des Eingangssignals am Eingang des ersten Inverters I1 gehalten wird.

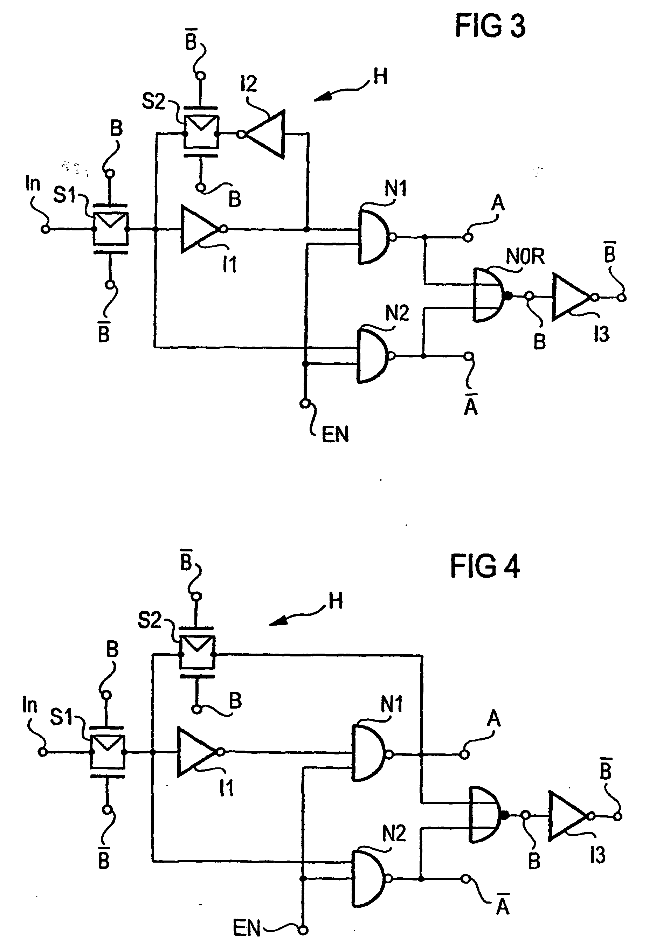

Figur 3 zeigt ein zweites Ausführungsbeispiel der digitalen Schaltung aus Figur 1, das die Erfindung erläutert und sich in folgenden Punkten vom Ausführungsbeispiel aus Figur 2 unterscheidet: das erste Schaltelement S1 ist ein Transfergate, das einen n-Kanal- und einen p-Kanal-Transistor aufweist. Dem NOR-Gatter ist ein dritter Inverter I3 nachgeschaltet. Am Ausgang des NOR-Gatters erzeugt dieses ein Signal B, das am Ausgang des dritten Inverters I3 als invertiertes Signal /B vorliegt. Der p-Kanal-Transistor des ersten Schaltelementes S1 ist mit dem Ausgang des NOR-Gatters und der n-Kanal-Transistor mit dem Ausgang des dritten Inverters I3 verbunden. Weiterhin weist die Halteeinheit in ihrem Rückopplungszweig zwischen dem Ausgang des zweiten Inverters I2 und dem Eingang des ersten Inverters I1 ein zweites Schaltelement S2 auf, das ebenfalls ein Transfergate ist. Dessen p-Kanal-Transistor ist mit dem Ausgang des dritten Inverters I3 und dessen n-Kanal-Transistor ist mit dem Ausgang des NOR-Gatters verbunden. Hierdurch ist das zweite Schaltelement S2 immer dann gesperrt, wenn das erste Schaltelement S1 leitend ist. Außerdem ist das zweite Schaltelement S2 immer dann leitend, wenn das erste Schaltelement S1 gesperrt ist. Das zweite Schaltelement S2 verhindert einen Verluststrom zwischen dem Ausgang des zweiten Inverters I2 und den Treibern des Eingangssignals am Eingang In, da die beiden Schaltelemente S1, S2 niemals gleichzeitig leitend geschaltet sind. Die Haltefunktion der Halteeinheit H ist nur notwendig, wenn das erste Schaltelement S1 gesperrt ist.

Figur 4 zeigt ein weiteres erfindungsgemäßes Ausführungsbeispiel der digitalen Schaltung aus Figur 1. Dieses unterscheidet sich vom Ausführungsbeispiel aus Figur 3 hinsichtlich des Eingangs des Rückkopplungszweiges der Halteeinheit H. In Figur 4 verbindet der Rückkopplungszweig den Ausgang des ersten NAND-Gatters N1 über das zweite Schaltelement S2 mit dem Eingang des ersten Inverters I1. Am ersten Ausgang A liegt während des deaktivierten Zustands der digitalen Schaltung immer der hohe logische Pegel 1 an. Da das zweite Schaltelement S2 dann gesperrt ist, wirkt sich dieser Pegel nicht auf das Potential am Eingang des ersten Inverters I1 aus. Das Ausführungsbeispiel aus Figur 4 hat gegenüber demjenigen in Figur 3 den Vorteil, daß der zweite Inverter I2 entfällt. Somit kann die Schaltung aus Figur 4 mit weniger Schaltungskomponenten realisiert werden, als diejenige in Figur 3.

## Patentansprüche

1. Digitale Schaltung
- mit einem Eingang (In) zur Zuführung eines Eingangssignals über ein erstes Schaltelement (S1),
- mit einem Aktivierungseingang (EN), über den sie in einen aktivierten und in einen deaktivierten Zustand versetzbar ist,
- mit einem ersten Ausgang (A), an dem sie im aktivierten Zustand denjenigen Pegel des Eingangssignals nicht invertiert ausgibt, den dieses direkt vor einem Sperren des ersten Schaltelementes (S1) aufweist,
- mit einem zweiten Ausgang (/A), an dem sie im aktivierten Zustand denjenigen Pegel des Eingangssignals invertiert ausgibt, den dieses direkt vor dem Sperren des ersten Schaltelementes (S1) aufweist,
- die im deaktivierten Zustand an beiden Ausgängen (A, /A) einen ersten logischen Pegel (1) ausgibt,
- mit einer Logikeinheit (L), die eingangsseitig mit den beiden Ausgängen (A, /A) der Schaltung verbunden ist und die ausgangsseitig mit einem Steueranschluß des ersten Schaltelementes (S1) verbunden ist,
- wobei die Logikeinheit (L) das erste Schaltelement (S1) leitend schaltet, wenn an beiden Ausgängen (A, /A) der Schaltung der erste logische Pegel (1) anliegt,
- und wobei die Logikeinheit (L) das erste Schaltelement (S1) sperrt, wenn an einem der beiden Ausgänge (A, /A) ein zweiter logischer Pegel (0) anliegt,
**dadurch gekennzeichnet, dass**
- eine Halteeinheit (H) in einem Rückkopplungszweig vom Ausgang der Logikeinheit (L) nach dem Sperren des ersten Schaltelementes (S1) eine Änderung der Pegel an den Ausgängen (A, /A) der Schaltung verhindert, solange die Schaltung aktiviert ist, und ein zweites Schaltelement (S2) mit einem Steuereingang aufweist, der mit dem Ausgang der Logikeinheit (L) verbunden ist,
- die Logikeinheit (L) das zweite Schaltelement (S2) sperrt, wenn an beiden Ausgängen (A, /A) der Schaltung der erste logische Pegel (1) anliegt, und
- die Logikeinheit (L) das zweite Schaltelement (S2) leitend schaltet, wenn an einem der beiden Ausgänge (A, /A) der zweite logische Pegel (0) anliegt.

2. Digitale Schaltung nach Anspruch 1,
**dadurch gekennzeichnet, dass**
- das erste Schaltelement (S1) über einen ersten Inverter (I1) mit einem ersten Eingang eines ersten NAND-Gatters (N1) und direkt mit einem ersten Eingang eines zweiten NAND-Gatters (N2) verbunden ist,
- zweite Eingänge der NAND-Gatter (N1, N2) mit dem Aktivierungseingang (EN) verbunden sind,
- der erste Ausgang (A) ein Ausgang des ersten NAND-Gatters (N1) und der zweite Ausgang (/A) ein Ausgang des zweiten NAND-Gatters (N2) ist.

3. Digitale Schaltung nach Anspruch 2,
**dadurch gekennzeichnet, dass**
die Logikeinheit (L) ein NOR-Gatter aufweist.

4. Digitale Schaltung nach Anspruch 1 und 2,
**dadurch gekennzeichnet, dass**
der Rückkopplungszweig zwischen dem ersten Ausgang (A) und dem Eingang des ersten Inverters (I1) angeordnet ist.

## Revendications

1. Circuit numérique
- comprenant une entrée (In) d'envoi d'un signal d'entrée par un premier élément (S1) de commutation,
- comprenant une entrée (EN) d'activation, par laquelle il peut être mis dans un état activé ou dans un état désactivé,
- comprenant une première sortie (A) sur laquelle il émet de façon non inversé à l'état activé, le niveau du signal d'entrée que ce signal a juste avant un blocage du premier élément (S1) de commutation,
- comprenant une deuxième sortie (/A) sur laquelle il émet de façon inversée à l'état activé, le niveau du signal d'entrée que ce signal a juste avant le blocage du premier élément (S1) de commutation.
- qui émet, à l'état désactivé, sur les deux sorties (A, /A) un premier niveau (1) logique,
- comprenant une unité (L) logique qui est reliée du côté entrée aux deux sorties (A, /A) du circuit et qui est reliée du côté sortie à une borne de commande du premier élément (S1) de commutation,
dans lequel l'unité (L) logique met le premier élément (S1) de commutation à l'état passant lorsque le premier niveau (1) logique s'applique aux deux sorties (A, /A) du circuit,
- et dans lequel l'unité (L) logique bloque le premier élément (S1) de commutation lorsqu'un deuxième niveau (0) logique s'applique à l'une des deux sorties (A, /A)
**caractérisé en ce que**
- une unité (H) de maintien dans une branche de réaction, partant de la sortie de l'unité (L) logique, empêche, après le blocage du premier élément (S1) de commutation, que le niveau sur les sorties (A, /A) se modifie tant que le circuit est activé, et a un deuxième élément (S2) de commutation ayant une entrée de commande, qui est reliée à la sortie de l'unité (L) logique,
- l'unité (L) logique bloque le deuxième élément (S2) de commutation lorsque le premier niveau (1) logique s'applique aux deux sorties (A,/A) du circuit, et
- l'unité (L) logique rendant passant le deuxième élément (S2) de commutation lorsque le deuxième niveau (0) logique s'applique à l'une des deux sorties (A, /A).

2. Circuit numérique suivant la revendication 1, **caractérisé en ce que**
- le premier élément (S1) de commutation est relié par un premier inverseur (I1) à une première entrée d'une première porte (N1) NON-ET et est relié directement à une première entrée d'une deuxième porte (N2) NON-ET,
- deux entrées des portes (N1, N2) NON-ET sont reliées à l'entrée (EN) d'activation,
- la première sortie (A) est une sortie de la première porte (N1) NON-ET et la deuxième sortie (/A) est une sortie de la deuxième porte (N2) NON-ET.

3. Circuit numérique suivant la revendication' 2, **caractérisé en ce que** l'unité (L) logique a une porte NON-OU.

4. Circuit numérique suivant la revendication 1 et 2, **caractérisé en ce que** la branche de réaction est disposée entre la première sortie (A) et l'entrée du premier inverseur (I1).

## Claims

1. Digital circuit
- with an input (In) for supplying an input signal via a first switching element (S1),
- with an activation input (EN), via which said circuit can be set to an activated state and a deactivated state,
- with a first output (A), at which, in the activated state, it outputs in a non-inverted form that level of the input signal which the latter has directly before a blocking of the first switching element (S1),
- with a second output (/A), at which, in the activated state, it outputs in an inverted form that level of the input signal which the latter has directly before the blocking of the first switching element (S1),
- which, in the deactivated state, outputs a first logic level (1) at both outputs (A, /A),
- with a logic unit (L), which is connected on the input side to the two outputs (A, /A) of the circuit and which is connected on the output side to a control connection of the first switching element (S1),
- the logic unit (L) switching the first switching element (S1) to conductive when there is a first logic level, (1) at the two outputs (A, /A) of the circuit,
- and the logic unit (L) blocking the first switching element (S1) when there is a second logic level (0) at one of the two outputs (A, /A),
**characterized in that**
- a holding unit (H) in a feedback branch from the output of the logic unit (L) prevents any change in the levels at the outputs (A, /A) of the circuit after the blocking of the first switching element (S1) for as long as the circuit is activated, and has a second switching element (S2) with a control input, which is connected to the output of the logic unit (L),
- the logic unit (L) blocks the second switching element (S) when the first logic level (1) is present at both outputs (A, /A) of the circuit, and
- the logic unit (L) switches the second switching element (S2) to conductive when the second logic level (0) is present at one of the two outputs (A, /A) .

2. Digital circuit according to Claim 1,
**characterized in that**
- the first switching element (S1) is connected via a first inverter (I1) to a first input of a first NAND gate (N1) and is connected directly to a first input of a second NAND gate (N2),
- second inputs of the NAND gates (N1, N2) are connected to the activation input (EN),
- the first output (A) is an output of the first NAND gate (N1) and the second output (/A) is an output of the second NAND gate (N2).

3. Digital circuit according to Claim 2, **characterized in that** the logic unit (L) has a NOR gate.

4. Digital circuit according to Claims 1 and 2, **characterized in that** the feedback branch is arranged between the first output (A) and the input of the first inverter (I1).
